(19) **Europäisches Patentamt**

**European Patent Office**

**Office européen des brevets**

(11) **EP 0 714 167 B1**

(12) **EUROPÄISCHE PATENTSCHRIFT**

(45) Veröffentlichungstag und Bekanntmachung des Hinweises auf die Patenterteilung:
**20.02.2002 Patentblatt 2002/08**

(51) Int Cl.⁷: **H03K 5/02**

(21) Anmeldenummer: **95117895.3**

(22) Anmeldetag: **14.11.1995**

(54) **Digitale Treiberschaltung für eine integrierte Schaltung**

Digital driver circuit for an integrated circuit

Circuit d'attaque numérique pour des circuits intégrés

(84) Benannte Vertragsstaaten:
**DE FR GB IT NL**

(30) Priorität: **22.11.1994 DE 4441523**

(43) Veröffentlichungstag der Anmeldung:
**29.05.1996 Patentblatt 1996/22**

(73) Patentinhaber: **Micronas GmbH**
**79108 Freiburg (DE)**

(72) Erfinder:
• **Caesar, Knut, Dipl.-Ing.**
**D-79108 Freiburg (DE)**
• **Greitschus, Norbert, Dipl.-Ing.**
**D-79108 Freiburg (DE)**

(56) Entgegenhaltungen:
**EP-A- 0 130 079     EP-A- 0 284 356**
**EP-A- 0 463 316     EP-A- 0 547 349**

• **'Auto Programming Lumped Load Off-Chip Drivers' IBM TECHNICAL DISCLOSURE BULLETIN Bd. 30, Nr. 7, 01 Dezember 1987, ARMONK, NY, Seiten 23 - 25**

**Beschreibung**

Die Erfindung betrifft eine digitale Treiberschaltung für eine integrierte Schaltung (IC), insbesondere für ICs, bei denen sowohl analoge als auch digitale Baugruppen auf einem Halbleitersubstrat angeordnet sind.

Mit solchen Treiberschaltungen werden nachfolgende Bauelemente, die eine kapazitive Last aufweisen, betrieben. Die Lastkapazität bestimmt den Strom, der zu ihrem Umladen erforderlich ist. Bei großen Kapazitäten und festen Umladezeiten ist ein hoher Strom erforderlich. Ein hoher Umladestrom erzeugt durch die in der Schaltung vorhandenen Induktivitäten und Widerstände Störspannungen sowie Einbrüche der Versorgungsspannung, welche einem Rauschen der internen Spannungsversorgung bzw. einem Rauschen des Eingangssignals entspricht. Das Rauschen nimmt zudem mit der Anzahl der Umladungen und der Umladegeschwindigkeit zu. Bei einem IC mit einer großen Anzahl von digitalen Ausgängen mit hohen Datenraten sind die Störungen durch das so erzeugte Rauschen des Eingangssignals besonders groß. Zudem hängt die Lastkapazität des von der Treiberschaltung anzutreibenden Bauelementes von der jeweiligen Anwendung, d.h. von dem jeweiligen Kunden ab. Die Treiberschaltung muß also so ausgelegt sein, daß sie für verschiedene Lastkapazitäten verwendet werden kann. Dadurch wird eine optimale Anpassung des Stromes an die Nachfolgebedingung und eine genau vorhersehbare Leistung der Treiberschaltung schwierig.

Üblicherweise wird die Treiberschaltung für den "worst case" ausgelegt. Dem entspricht die größte Lastkapazität, die einer der Kunden verwenden kann, und die kürzeste Zeit, die zum Umladen der Lastkapazität erforderlich ist, etwa im Fall hoher Datenraten. In diesem Fall ist ein hoher Strom erforderlich, der ein relativ großes Rauschen des Eingangssignal zur Folge hat. Bei dieser Auslegung ist die Treiberschaltung zwar für alle Anwendungen einsetzbar, jedoch ist der Strom in einem günstigerem Fall, als dem des "worst cases" unnötig hoch, wodurch in diesen Fällen ein unnötiges Rauschen erzeugt wird. Der Unterschied des Stromes für den in dem "best case" erforderlichen Strom im Vergleich zu dem "worst case" kann beispielsweise einen Faktor 4 betragen.

In der DE 42 33 850 (ITT-Case C-DIT-1449) wird ein Verfahren für eine Treiberschaltung vorgeschlagen, bei dem der Strom der Ausgangsstufe einstellbar ist. Durch eine geeignete Strom- und Spannungssteuerung wird eine zeitliche Verzögerung erzielt, die zu einer langsameren Stromerhöhung führt. Hierdurch können sehr hohe Strompeaks vermieden werden. Bei einer sehr hohen Datenrate kann dieses Verfahren jedoch nicht angewendet werden, da keine Zeit für diese Verzögerung der Stromsignale vorhanden ist.

Den nächstliegenden Stand der Technik beschreibt "IBM Technical Disclosure Bulletin 30" (1987), Dec. No. 7, Seiten 23-25. Dort wird eine adaptive Treiberschaltung gemäß den Oberbegriffsmerkmalen des Anspruchs 1 beschrieben. Über einen Vergleich der rückgeführten Ausgangsflanke wird die Anzahl der parallel zu schaltenden Gegentakt-Ausgangstreiber bestimmt.

Eine ähnliche Schaltung ist auch in EP 0 463 316 A 1 beschrieben. Die parallel zu schaltenden Impedanzen der Ausgangstreiber sind hierbei gewichtet, damit durch die Umschaltung ein größerer Impedanzbereich als bei ungewichteten Ausgangstreibern überstrichen werden kann.

In EP 0 547 349 A2 werden unterschiedlich gewichtete Ausgangstreiber über eine Fühlerschaltung aktiviert, die technologische, spannungs- und temperaturbedingte Toleranzen dynamisch mittels eines Ringoszillators über einen Frequenzvergleich mit einer Systemtaktfrequenz auswertet.

Der Erfindung liegt die Aufgabe zugrunde, eine digitale Treiberschaltung für eine integrierte Schaltung zu schaffen, die auch bei mehreren digitalen Augängen und hohen Datenraten eine angemessene Leistung für verschiedene an die jeweilige Anwendung angepaßte Treiberstärken für das nachfolgende Bauelement gewährleistet.

Diese Aufgabe wird durch eine digitale Treiberschaltung mit einer Ausgangsstufe, die wenigstens zwei zueinander parallel geschaltete, Ausgangstransistoren aufweisende Ausgangszweige, einem Steuermittel zum Ansteuern der Ausgangsstufe, einer Eingabevorrichtung zum Eingeben einer Maßzahl, einem Einstellmittel zum Ermitteln einer bestimmten Ausgangszweigen zugeordneten Stellgröße aufgrund der Maßzahl und einem Schaltmittel zum Freigeben der bestimmten Ausgangszweige gelöst.

Die erfindungsgemäße Treiberschaltung kann somit an eine bestimmte Anwendung vom Kunden selbst angepaßt werden. Er muß je nach Art der Anwendung, d.h. je nach der Lastkapazität seines mit der Treiberschaltung zu betreibenden Bauelements und der Datenrate (die kürzeste Zeit eines Informationswechsels der Treiberschaltung), die entsprechende Maßzahl in die Eingabevorrichtung eingeben. Die Maßzahl ist eine von der Anwendung abhängige Größe, die ein vorübergehendes Maß für die Anzahl der anzusteuernden Ausgangszweige ist Mit dem Einstellmittel wird dann eine entsprechende Stellgröße ermittelt, die eine entsprechende Anzahl von Ausgangsstufen frei gibt, so daß nur diese Ausgangszweige angesteuert werden. Abhängig von der Lastkapazität und der Datenrate wird also nur eine vorgegebene Anzahl der Ausgangszweige der Treiberschaltung zum Antrieb der Lastkapazität verwendet. Hierdurch wird ein unnötiges Rauschen aufgrund unnötig hoher Ströme bei Anwendungen, die nicht dem "worst case" entsprechen, vermieden. Die Leistung der Treiberschaltung ist an die jeweilig Anwendung anpaßbar.

Es ist vorteilhaft, wenn die Ausgangszweige unterschiedlich gewichtet sind. Dies kann beispielsweise durch unterschiedliche Auslegung der entsprechenden Ausgangstransistoren, insbesondere deren W/L-Verhältnis realisiert werden. Durch entsprechende Wahl der Ausgangszweige wird die Variationsmöglichkeit der Treiberstärke weiter erhöht. Auch können die Ausgangszwige als Push-Pull-Stufen ausgebildet sein.

Gemäß einer vorteilhaften Weiterbildung der Erfindung ist ein Sensor zum Messen einer elektrischen Größe zum Ermitteln einer Korrekturgröße vorgesehen, mit welcher die Stellgröße korrigiert wird. Die Korrekturgröße dient zur Berücksichtigung von Prozeßparametern, die unterschiedlich sein können. Solche Parameter sind beispielsweise die Oxiddicke, die Temperatur, die Betriebsspannung etc.. Aufgrund der Korrekturgröße kann die Treiberstärke so gewählt werden, daß die minimale Geschwindigkeit der Signale, d.h. der Anstiegs- bzw. Abfallzeiten bei der entsprechenden Anwendung gerade noch ausreichend für die Funktion der Treiberschaltung ist. Mit der Korrekturgröße wird die aufgrund der vorgegebenen Maßzahl bestimmte Stellgröße korrigiert. Mit der Maßzahl ist also eine Voreinstellung auf die entsprechende Anwendung möglich, die aufgrund der durch Messen bestimmten Korrekturgröße an die jeweiligen Prozeßparameter angeglichen wird.

Günstigerweise erfolgt das Messen der elektrischen Größe mit einer vorgegebenen Meßrate. Damit ist ein regelmäßiges Überwachen der Prozeßparameter und eine entsprechendes Angleichen der Stellgröße möglich. Für die praktische Durchführung ist es einfach, wenn eine konstante Meßrate gewählt wird. Die Meßrate ist günstigerweise klein gegenüber der Datenrate der Ausgangsignale, mit der die Daten übertragen werden.

Vorteilhafterweise wird eine zu der Anstiegs- bzw. Abklingzeit des Ausgangssignals der Treiberschaltung äquivalente elektrische Größe gemessen. Dies ist insbesondere bei Push-Pull-Stufen vorteilhaft, da in diesem Fall die Anstiegs- bzw. Abfallzeit eine Funktion der Lastkapazität, Versorgungsspannung, Temperatur und Prozeßlage ist.

Zur Bestimmung der Korrekturgröße kann der Sättigungsstrom eines oder mehrerer Meßtransistoren gemessen werden. In guter Nährung für in der Praxis verwendete Ausgangsstransistoren, ist die Anstiegs- bzw. Abklingzeit und damit die aktuelle Schaltgeschwindigkeit umgekehrt proportional zum Sättigungsstrom des MOS-Transistors. Zur Bestimmung des Sättigungsstroms kann vorteilhafterweise ein A/D-Wandler verwendet werden.

Gemäß einer Weiterbildung der Erfindung kann der A/D-Wandler einen Zähler zum Bestimmen der Stellgröße aus der Maßzahl und der Korrekturgröße umfassen. Durch Zählen in bestimmten Zeitintervallen kann so die Stromstärke bestimmt werden. Durch die Maßzahl wird die Anfangszahl, mit der der Zähler zu zählen beginnt, festgelegt.

Gemäß einem weiteren Ausführungsbeispiel der Erfindung kann eine Prozessor zum Bestimmen der Stellgröße aus der Maßzahl und der Korrekturgröße vorgesehen sein. In diesem Fall kann jeder beliebige A/D-Wandler verwendet werden. Die Stellgröße wird mit dem Prozessor aus der Maßzahl und der Korrekturgröße berechnet. Der Berechnung kann eine in dem Programm vorhandene Tabelle mit den Abhängigkeiten von entsprechenden Prozeßparametern zugrundeliegen. Es kann ebenfalls eine genaue Rechnung ausgeführt werden, je nachdem welche Genauigkeit bei der Anwendung erforderlich ist.

Auch kann eine getrennte Spannungsversorgung für die Ausgangsstufe vorgesehen sein. Die Ausgangsstufe kann dann mit unabhängigen Betriebsspannung betrieben werden.

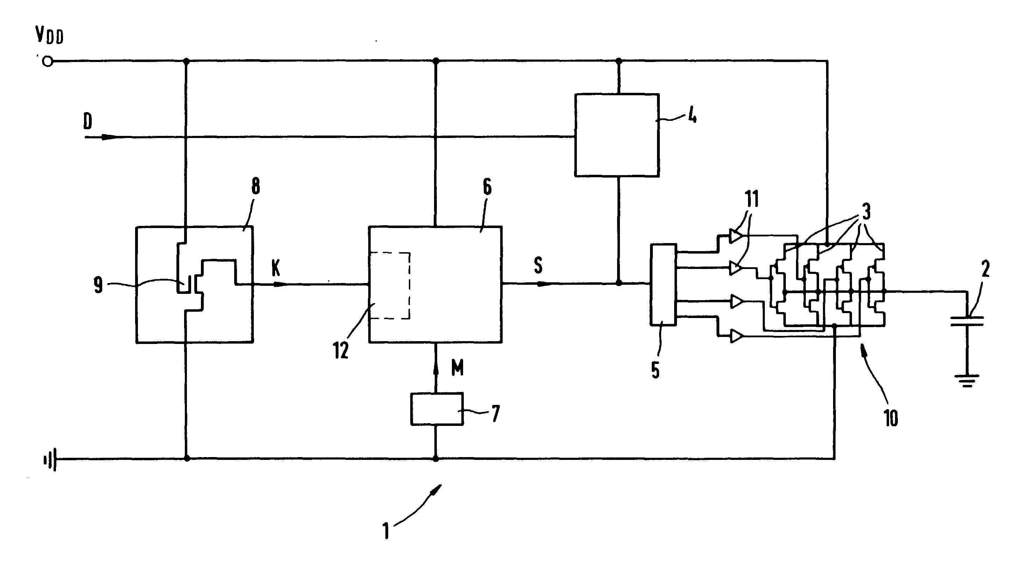

Im folgenden wird die Erfindung anhand der Zeichnung näher beschrieben.

Die Figur zeigt eine schematische Darstellung eines Ausführungsbeispieles der erfindungsgemäßen Treiberschaltung.

Die in der Figur gezeigte digitale Treiberschaltung 1 ist mit einer Lastkapazität 2 eines mit der Treiberschaltung 1 zu betreibenden Bauelements verbunden. Die digitale Treiberschaltung 1 ist mit weiteren analogen und digitalen Baugruppen auf einem nicht gezeigten Halbleitersubstrat, beispielsweise einem Siliziumkristall integriert. Die Treiberschaltung 1 bildet die Endstufe dieses ICs.

Die gezeigte digitale Treiberschaltung 1 weist eine Ausgangsstufe 10 mit vier zueinander parallel gaschalteten Ausgangszweigen 3 auf. Jeder Ausgangszweig 3 umfaßt einen p-Kanal- und einen n-Kanal-MOS-Transistor und bildet eine Push-Pull-Stufe. Abhängig von der Anwendung kann aber auch jeder Ausgangszweig 3 nur einen MOS-Transistor eines Leitungstyps umfassen. Es kann abhängig von der Anwendung eine beliebige Anzahl der Ausgangszweige 3 verwendet werden. Die Ansteuerung der parallel geschalteten Ausgangszweige 3 erfolgt mit einem auf dem IC integrierten Steuermittel 4. Die Ausgangszweige 3 sind mit einem Schaltmittel 5 verbunden, durch welches bestimmte Ausgangszweige 3 freigegeben werden können. Zwischen dem Schaltmittel 5 und den Ausganszweigen 3 ist jeweils ein Vorverstärker 11 bzw. ein Prätreiber angeordnet. Welche der Ausgangszweige 3 freigegeben werden, hängt von einer Stellgröße S ab, welche von einem Einstellmittel 6 ermittelt und an das Schaltmittel 5 weitergegeben wird. Das Einstellmittel 6 ist mit einer Eingabevorrichtung 7 verbunden, in die ein Benutzer eine Maßzahl M eingeben kann. Ausgehend von dieser Maßzahl M kann in dem Einstellmittel 6 die Stellgröße S berechnet werden. Die Maßzahl M wird von dem Benutzer, abhängig von der Anwendung, die insbesondere die zu betreibenden Lastkapazität 2 bestimmt, gewählt. Ferner ist eine Meßvorrichtung 8 vorgesehen, die mit dem Einstellmittel 6 verbunden ist. Die Meßeinrichtung 8 enthält einen Meßtransistor 9 zum Messen einer elektrischen Größe, mit der eine Korrekturgröße K ermittelt werden kann. Die Korrekturgröße K wird von der Meßvorrichtung 8 an das Einstellmittel 6 weitergegeben. In dem Einstellmittel 6 kann die dort zunächst aufgrund der Maßzahl M vorbestimmte Stellgrößen korrigiert werden.

In der Meßvorrichtung 8 wird der Sättigungsstrom des Meßtransistors 9 zur Bestimmung der Korrekturgröße K gemessen. Diese Korrekturgröße K berücksichtigt Größen wie Prozeßparameter, beispielsweise Oxiddicken oder sonstige Parameter, die aufgrund des Herstellungsprozesses Streuungen aufweisen, Versorgungsspannung $V_{DD}$, Temperatur etc.. Der Meßtransistor 9 muß so angeordnet und ausgelegt sein, daß der Transistorstrom unter Bedingungen gemessen wird, die im wesentlichen den Bedingungen entsprechen, die den Strom der Ausgangstransistoren der Ausgangszweige 3 bestimmen. Zu diesem Zweck können auch mehrere Meßtransistoren angeordnet sein. Der Typ der Leitfähigkeit des Meßtransistors 9 und dessen W/L-Verhältnisses sowie seine räumliche Anordnung, die Versorgungsspannung etc. müssen entsprechend gewählt werden. Er kann aus mehreren Transitoren bestehen. Auch wird der Strom in der Meßeinrichtung üblichen Maßnahmen, wie Signalglättung, unterzogen.

Der Sättigungsstrom des Meßtransistors 9 ist unter üblichen Bedingungen ein hinreichendes Maß zum Bestimmen der Korrekturgröße K, die die oben genannten Parameter berücksichtigen soll. In erster Näherung, die unter gewöhnlichen Betriebsbedingungen für MOS-Transistoren erfüllt ist, ist der Sättigungsstrom eines MOS-Transistors, dessen Gate-Source-Spannung gleich der Versorgungsspspannung $V_{DD}$ ist, umgekehrt proportional zu der Anstiegs- bzw. Abfallzeit des Ausgangssignals der Ausgangstransistoren bei Belastung durch die Kapazität 2. Die Anstiegs- bzw. Abfallzeit läßt sich also direkt aus dem Sättigungsstrom des Transistors bestimmen. Die Anstiegs-bzw. Abfallzeit ist eine Funktion der Lastkapazität 2, der Versorgungsspannung $V_{DD}$, der Temperatur, der Prozeßlage etc.. Für eine einfache Push-Pull-Stufe gilt dabei folgender Zusammenhang:

$$t_{R,F} = \tau * I \frac{2 * V_{DD}}{V_{DD} - |V_T|} - 2 + \ln \left( \frac{2 * (V_{DD} - |V_T|)}{V_H} - 1 \right)$$

mit

$$\tau = C_L * \frac{1}{w * \beta'} * (V_{DD} - |V_T|)^{-1}$$

Dabei bedeutet:

| | |
|---|---|
| $V_{DD}$ | Versorgungsspannung |
| $V_T$ | Schwellspannung |
| $V_H$ | Schaltspannungshub |
| w, l | Transistorgeometrie |
| $\beta'$ | Transkonduktanz |
| $C_L$ | Lastkapazität |

Die aus der Messung des Sättigungsstromes des Meßtransistors 9 bestimmte Korrekturgröße K ist ein Maß dafür, wie sehr die aufgrund der Maßzahl M bestimmte Stellgröße S korrigiert werden muß. Dies Korrektur erfolgt in dem Einstellmittel 6. Der Strom des Meßtransistors 9 kann mit einer bestimmte Meßrate gemessen werden. Die Meßrate kann dabei konstant sein. Wesentlich ist, daß die Meßrate klein gegenüber der Datenrate des Ausgangssignals der Ausgangsstufen 3 ist, mit der die Daten übertragen werden.

Das Einstellmittel 6 enthält einen A/D-Wandler 12, der aus der Korrekturgröße K einen digitalen Wert erzeugt. Die Art des A/D-Wandlers 12 kann abhängig von der Art des Weiterverarbeitung des von ihm erzeugten Signals gewählt werden. Der A/D-Wandler 12 kann einen Zähler umfassen. In diesem Fall wäre die Maßzahl M dem A/D-Wandler 12 bzw. dem Zähler direkt zuzuführen. Die Maßzahl M bildet den Startwert für den Zähler. Abhängig von der Stromgröße des Meßtransistors 9 wird der Startwert des Zählers vergrößert oder vermindert. Die Stromgröße und damit der Zählwert bestimmt direkt den Stellwert S. Der Zähler kann einen Begrenzer umfassen, so daß er in einem eingeschränkten Regelbereich arbeitet. Überläufe des Zählers werden bei der Signalauswertung dann entsprechend berücksichtigt.

Das Einstellmittel 6 kann aber auch einen A/D-Wandler 12 anderer Art enthalten. Dann muß noch ein Prozessor, z.B. in dem Einstellmittel 6 enthalten sein. Dieser bestimmt aus der Maßzahl und der Korrekturgröße die an die Prozeßparameter angepaßte Stellgröße. Die Stellgröße kann sowohl nur Informationen über die Anzahl der anzusteuernden Ausgangszweige 3 enthalten. Sie kann aber auch Informationen darüber enthalten, welche der Ausgangszweige 3 angesteuert werden sollen. Letzteres ist dann sinnvoll, wenn die Ausgangszweige 3 unterschiedlich gewichtet sind. Denn dann kann eine genauere Auswahl der an die entsprechenden Bedingungen angepaßten Stellgröße S vorgenommen werden.

**Patentansprüche**

1. Digitale Treiberschaltung für eine integrierte Schaltung (IC) mit einer Ausgangsstufe (10), die wenigstens zwei zueinander parallel geschaltete, Ausgangstransistoren aufweisende Push-Pull-Ausgangszweige (3) aufweist, einem Steuermittel (4) zum Ansteuern der Ausgangsstufe (10), einer Eingabevorrichtung (7) zum Eingeben einer Maßzahl M, einem Einstellmittel (6) zum Ermitteln einer bestimmten Ausgangszweigen (3) zugeordneten Stellgröße S aufgrund der Maßzahl M, einem Schaltmittel (5) zum Freigeben der bestimmten Ausgangszweige (3) und mit einem Sensor zum Messen einer elektrischen Größe zum Ermitteln einer Korrekturgröße K, mit welcher die Stellgröße S korrigiert wird, **dadurch gekennzeichnet, daß** zur Bestimmung der Korrekturgröße K ein Sättigungsstrom bei einer festen Gate-Source spannung eines oder mehrerer Meßtransistoren (9) gemessen wird.

2. Digitale Treiberschaltung nach Anspruch 1, **dadurch gekennzeichnet, daß** die Push-Pull-Ausgangszweige (3) unterschiedlich gewichtet sind.

3. Digitale Treiberschaltung nach einem der vorangehenden Ansprüche, **dadurch gekennzeichnet, daß** das Messen der elektrischen Größe mit einer vorgegebenen Meßrate erfolgt.

4. Digitale Treiberschaltung nach Anspruch 5, **dadurch gekennzeichnet, daß** die Meßrate klein gegenüber der Datenrate des Ausgangssignals ist, mit der die Daten übertragen werden.

5. Digitale Treiberschaltung nach einem der vorangehenden Ansprüche, **dadurch gekennzeichnet, daß** zur Bestimmung des Sättigungsstromes ein A/D-Wandler (12) verwendet wird.

6. Digitale Treiberschaltung nach Anspruch 5, **dadurch gekennzeichnet, daß** der A/D-Wandler (12) einen Zähler zum Bestimmen der Stellgröße S aus der Maßzahl M und der Korrekturgröße K umfaßt.

7. Digitale Treiberschaltung nach einem der vorangehenden Ansprüche, **dadurch gekennzeichnet, daß** ein Prozessor zum Bestimmen der Stellgröße S aus der Maßzahl M und der Korrekturgröße K vorgesehen ist.

8. Digitale Treiberschaltung nach einem der vorangehenden Ansprüche, **dadurch gekennzeichnet, daß** eine getrennte Spannungsversorgung für die Ausgangszweige (3) vorgesehen ist.

## Claims

1. A digital driver circuit for an integrated circuit (IC), comprising an output stage (10) having at least two parallel-connected push-pull output branches (3) containing output transistors, a control means (4) for controlling the output stage (10), an input device (7) for entering a numerical measure M, a setting means (6) for determining a controlling variable S assigned to a particular output branch (3) by means of the numerical measure M, a switching means (5) for enabling the particular output branches (3), and a sensor for measuring an electrical quantity to determine a correction quantity K with which the controlling variable is corrected, **characterized in that**, to determine the correction quantity K, a saturation current at a fixed gate-to-source voltage of one or more measuring transistors (9) is measured.

2. A digital driver circuit as claimed in claim 1, **characterized in that** the output branches (3) are weighted differently.

3. A digital driver circuit as claimed in either of the preceding claims, **characterized in that** the electrical quantity is measured at a predetermined measuring rate.

4. A digital driver circuit as claimed in claim 3, **characterized in that** the measuring rate is small compared to the output data rate, at which the data is transferred.

5. A digital driver circuit as claimed in any one of the preceding claims, **characterized in that** an A/D converter (12) is used to determine the saturation current.

6. A digital driver circuit as claimed in claim 5, **characterized in that** the A/D converter (12) comprises a counter for determining the controlling variable S from the numerical measure M and the correction quantity K.

7. A digital driver circuit as claimed in any one of the preceding claims, **characterized in that** a processor is provided for determining the controlling variable S from the numerical measure M and the correction quantity K.

8. A digital driver circuit as claimed in any one of the preceding claims, **characterized in that** a separate power supply is provided for the output branches (3).

## Revendications

1. Circuit d'attaque numérique pour un circuit intégré (IC) comportant un étage de sortie (10), qui comporte des branches de sortie push-pull (3) comprenant au moins deux transistors de sortie branchés en parallèle, un organe de commande (4) pour la commande de l'étage de sortie (10), un dispositif d'entrée (7) pour entrer un nombre de mesure M, un organe de réglage (6) pour déterminer, sur la base du nombre de mesure M, une grandeur de réglage S associée à une branche de sortie déterminée (3), un organe de commutation (5) pour libérer les branches de sortie (3) déterminées et un capteur pour mesurer une grandeur électrique afin de déterminer une grandeur de correction K au moyen de laquelle on corrige la grandeur de réglage S, **caractérisé en ce que,** pour la détermination de la grandeur de correction K, on mesure un courant de saturation, dans le cas d'une tension porte-source fixe, d'un ou plusieurs transistors de mesure (9).

2. Circuit d'attaque numérique selon la revendication 1, **caractérisé en ce que** les branches de sortie (3) en push-pull sont pondérés de manière différente.

3. Circuit d'attaque numérique selon l'une quelconque des revendications précédentes, **caractérisé en ce que** la mesure des grandeurs électriques est réalisée avec un débit de mesure prédéterminé.

4. Circuit d'attaque numérique selon la revendication 3, **caractérisé en ce que** la débit de mesure est faible par rapport au débit des données avec lequel les données sont transmises.

5. Circuit d'attaque numérique selon l'une quelconque des revendications précédentes, **caractérisé en ce que**, pour la détermination du courant de saturation, on utilise un convertisseur analogique-numérique (12)

6. Circuit d'attaque numérique selon la revendication 5, **caractérisé en ce que** le convertisseur analogique-numérique (12) comprend un compteur pour la détermination de la grandeur de réglage S à partir de nombre de mesure M et de la grandeur de correction K.

7. Circuit d'attaque numérique selon l'une quelconque des revendications précédentes, **caractérisé en ce que** l'on prévoit un processeur pour la détermination de la grandeur de réglage S à partir de nombre de mesure M et de la grandeur de correction K.

8. Circuit d'attaque numérique selon l'une quelconque des revendications précédentes, **caractérisé en ce que** l'on prévoit une alimentation en tension séparée pour les branches de sortie (3).